# EUROPEAN PATENT APPLICATION

(11) **EP 4 646 052 A1**
(43) Date of publication of application: **05.11.2025**
(21) Application number: 25172466.2
(22) Date of filing: 25.04.2025
(51) Int. Cl.: H10D 30/01, H10D 30/60, H10D 30/63

(54) **A LATERALLY DIFFUSED DEPLETION MODE TRANSISTOR AND METHOD OF FABRICATING**

(30) Priority: 29.04.2024 US 202418649367
(71) Applicant: Avago Technologies International Sales Pte. Limited, Singapore 768923 (SG)
(72) Inventor: Liu, Qing, Irvine, 92618 (US)
(74) Representative: Dilg, Haeusler, Schindelmann Patentanwaltsgesellschaft mbH

(57) **Abstract**

A transistor (103A) includes a first well region (122A) doped with second type dopants, a second well region (126) doped with first type dopants, and a third well region (118). The transistor (103A) also includes a first isolation structure (110A) neighboring the first well region (122A), a second isolation structure (112A) neighboring the the second well region (126) and the third well region (118), a drain region (108) doped with the first type dopants disposed in the third well region (118), a source region (104A) doped with the first type dopants disposed in the first well region (122A), and a gate (102A) disposed at least partially over the second isolation structure. The transistor (103A) can be configured as a depletion mode transistor.

## Description

### TECHNICAL FIELD

This disclosure relates to transistors including but not limited to laterally diffused depletion mode transistors. This disclosure also relates to structures and fabrication techniques for transistors including but not limited to structures and fabrication techniques for laterally diffused depletion mode transistors.

### BACKGROUND

Rapid advances in electronics and communication technologies, driven by immense customer demand, have resulted in the widespread adoption of electronic devices of every kind. The transistor is a fundamental circuit component of these devices. Transistors have a wide range of circuit applications, and field effect transistors (FETS) have been used in complementary metal oxide semiconductor (CMOS) integrated circuits (ICs). Types of transistors include N channel metal oxide semiconductor (NMOS) field effect transistors (FETs) and P channel metal oxide semiconductor (PMOS) field effect transistors (FETs). Improvements in transistor design improve the implementation, manufacturability, and operational characteristics of integrated circuits (ICs) used in electronic and communication devices.

### BRIEF DESCRIPTION OF THE DRAWING

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.
FIG. 1 is a planar top view schematic drawing of a depletion mode N channel metal oxide semiconductor (NMOS) FET structure according to some embodiments;
FIG. 2 is cross-sectional view schematic drawing of the depletion mode NMOS FET structure illustrated in FIG. 1 taken at line 2-2 according to some embodiments;
FIG. 3 is a planar top view schematic drawing of a depletion mode P channel metal oxide semiconductor (PMOS) FET structure according to some embodiments;
FIG. 4 is cross-sectional view schematic drawing of the depletion mode PMOS FET structure illustrated in FIG. 2 taken at line 4-4 according to some embodiments;
FIG. 5 is current versus voltage diagram showing performance of the depletion mode NMOS FET structure illustrated in FIG. 1 compared to an enhancement mode NMOS FET structure for various gate to source voltages according to some embodiments;
FIG. 6 is current versus voltage diagram showing performance of the depletion mode NMOS FET structure illustrated in FIG. 1 compared to an enhancement mode NMOS FET structure for various drain to source voltages according to some embodiments;
FIG. 7 is current versus voltage diagram showing performance of the depletion mode PMOS FET structure illustrated in FIG. 3 compared to an enhancement mode PMOS FET structure for various gate to source voltages according to some embodiments;
FIG. 8 is current versus voltage graph showing performance of the depletion mode PMOS FET structure illustrated in FIG. 3 compared to an enhancement mode PMOS FET structure for various drain to source voltages according to some embodiments;
FIG. 9 is a flow diagram showing operations for fabricating the depletion mode FET structures illustrated in FIGS. 1-4 according to some embodiments.

### DETAILED DESCRIPTION

Before turning to the features, which illustrate the exemplary embodiments in detail, it should be understood that the application is not limited to the details or methodology set forth in the description or illustrated in the figures. It should also be understood that the terminology is for the purpose of description only and should not be regarded as limiting.

Referring generally to the figures, a transistor and methods of making a transistor structure achieve improvements over enhancement mode transistors (e.g., NMOS and PMOS enhancement mode transistors structures) according to some embodiments. In some embodiments, a depletion mode transistor is fabricated using operations of 65 nm and below CMOS fabrication processes. In some embodiments, a depletion mode transistor is fabricated using operations of 28 nm/22 nm and below CMOS fabrication processes. The depletion mode transistor is an NMOS or PMOS depletion mode transistor in some embodiments. The depletion mode transistor is a laterally diffused (LD) NMOS or PMOS depletion mode transistor in some embodiments.

A pair of depletion mode transistors can share a single drain in certain layouts of an IC. A depletion-mode LDMOS FET is stacked on top of an enhancement-mode LD NMOS or PMOS transistor which improves breakdown voltage and limits drain current in case of overvoltage events in some embodiments.

In some embodiments, a depletion mode FET is used in analog circuits of IC designs for better performance in certain applications. The depletion mode transistor provides better performance for cascode structures by increasing voltage handling capability and reducing drain-source leakage in some embodiments. The depletion mode transistor provides better performance for high voltage load switches that control high-voltage loads with low-voltage control signals. The depletion mode transistor acts as a normally-on switch without a separate bias voltage to turn on the switch in some embodiments. The depletion mode transistor provides a current source that is independent of load variations in some embodiments. For example, a depletion mode LDMOS transistor can be used in current mirror designs for high-voltage applications and be configured to provide a stable current reference for high-voltage circuits. The depletion mode transistor provides a high-voltage voltage detector that detects high-voltage levels for protection or control purposes in some embodiments. The depletion mode LDMOS transistor provides an elegant and compact design compared to alternative voltage sensing methods in some embodiments.

An enhancement mode transistor generally refers to a transistor where gate current is effectively zero when the gate to source voltage (V_{GS}) is zero and biased by a drain to source voltage (V_{DS}). A depletion mode transistor refers to a transistor where gate current conducts when the gate to source voltage is zero and the transistor is biased by a drain to source voltage in some embodiments. In some embodiments, the gate current is a full operational current (e.g., operating in the saturation region) when appropriately biased by a drain to source voltage and the gate to source voltage is zero in the depletion mode. In some embodiments, a depletion mode MOSFET can include a physically implanted channel connecting the source side and the drain side. In an NMOS transistor, the channel includes an N-type silicon region connecting the highly doped N-type source and N-type drain regions on the top of a deep N well in a P-type substrate. In some embodiments, a depletion mode MOSFET can operate in either enhancement or depletion mode. For example, a positive V_{GS} makes a depletion mode NMOS work in the enhancement mode, while a negative V_{GS} makes the depletion mode transistor run in the depletion mode. A PMOS depletion mode transistor works essentially the same way as the depletion mode NMOS transistor, except that the currents and voltages in the two types are of opposite polarities in some embodiments.

In some embodiments, a depletion mode LDMOS transistor (e.g., having conduction at zero gate voltage (V_{GS}=0)) offers better transistor performance in certain applications. In some embodiments, an LDMOS depletion mode transistor is fabricated without modifying existing foundry processes for enhancement mode transistors, at a low cost associated with enhancement mode transistors, and/or at yields associated with enhancement mode transistors. Additional masks for process steps are not utilized when fabricating the depletion-mode LDMOS in some embodiments.

In some embodiments, N-type and P-type depletion mode LDMOS transistors utilize a unique structure and unique junction design using 40 nm technology and have a zero voltage gate conduction. In some embodiments, N-type and P-type depletion mode LDMOS transistors achieve improved on resistance (Ron) compared to enhancement mode transistors.

Some embodiments relate a transistor including a first well region doped with second type dopants, a second well region doped with first type dopants, and a third well region. The transistor also includes a first isolation structure neighboring the first well region, a second isolation structure neighboring the the second well region and the third well region, a drain region doped with the first type dopants disposed in the third well region, a source region doped with the first type dopants disposed in the first well region, and a gate disposed at least partially over the second isolation structure. The transistor is configured as a depletion mode transistor.

In some embodiments, a first distance in the first well region between the source region and an undoped region is between 0 and 150 nanometers. In some embodiments, a second distance in the undoped region between the first well region and the second well region is between 0 and 200 nanometers. In some embodiments, a first distance in an undoped region between the first well region and the second well region is between 0 and 200 nanometers.

In some embodiments, the drain region is a shared drain region. In some embodiments, the first and second isolation structures have a depth less than depths of the second well region and the first well region. In some embodiments, the transistor also includes an undoped region between a bottom of the first well region and the third well region and between the second well region and the third well region. In some embodiments, the third well region is doped with N type dopants.

Some embodiments relate to an integrated circuit. The integrated circuit includes a first well region doped with second type dopants, a second well region doped with first type dopants, and a third well region. The integrated circuit also includes a drain region doped with the first type dopants disposed in the third well region, a source region doped with the first type dopants disposed in the first well region, and a gate disposed between the source region and the drain region. A first distance in the first well region between the source region and an undoped region is between 0 and 150 nanometers.

In some embodiments, a second distance in the undoped region between the first well region and the second well region is between 0 and 200 nanometers. In some embodiments, the integrated circuit also includes a first isolation structure neighboring the first well region and a second isolation structure neighboring the the second well region and the third well region. In some embodiments, the drain region is a shared drain region. In some embodiments, the first and second isolation structures have a depth being less than depths of the second well region and the first well region. In some embodiments, the undoped region between a bottom of the first well region and the third well region and between the second well region and the third well region. In some embodiments, the third well region is doped with N type dopants.

Some embodiments relate to a method. The method includes providing a deep well doped with N type dopants, forming a first well region doped with first type dopants above the deep well, the first type dopants being one of the N type dopants or P type dopants, and forming a second well region doped with second type dopants above the deep well, the second type dopants being the other of the N type dopants or the P type dopants. The method also includes forming a first shallow trench isolation structure, forming a gate, forming a source region between the gate and the first shallow trench isolation structure above the first well region, and forming a drain region in the second well region. A first distance in the first well region between the source region and an undoped region is between 0 and 150 nanometers.

In some embodiments, a second distance in the undoped region between the first well region and the second well region is between 0 and 200 nanometers. In some embodiments, the method also includes forming a second shallow trench isolation structure neighboring the second well region and the drain region. In some embodiments, the undoped region is between the first well region and the deep well. In some embodiments, the second well region is provided in a third well region doped with the other dopants of the N type dopants or the P type dopants. Neighboring refers to a state of being next to or sharing at least a portion of a junction between two regions junction in some embodiments.

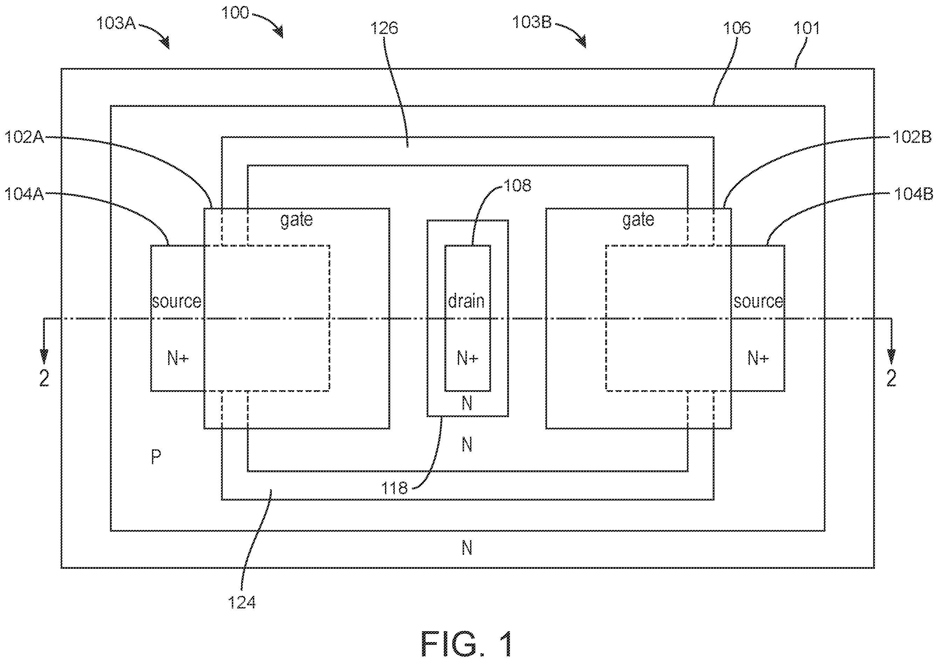

#With reference to FIGS. 1-2, an integrated circuit or semiconductor structure 100 is disposed on an insulative, semi-insulative, or semiconductor substrate 101. Substrate 101 can be a P type, N type, or non-doped silicon substrate in some embodiments. A pair of transistors 130A and 103B are provided on or within substrate 101. In some embodiments, the substrate 101 can be formed using any suitable material, such as silicon, silicon germanium, germanium, etc. The substrate 101 can include other structures (not shown) such as isolation layers, doped wells, and other structures that can be formed by deposition, etching, implantation and doping techniques. Substrate 101 is a bulk silicon substrate in some embodiments.

Substrate 101 includes a well region 105 provided around a perimeter of transistors 103A and 103B. Well region 105 is the deepest well region in substrate 101 and is moderately doped with N type dopants (e.g., concentration of 10¹⁵⁻¹⁷ dopants per cubic centimeter) in some embodiments. In some embodiments, well region 105 is a buried well region having a considerable depth in substrate 101 (e.g., 500 nanometers (nm) to 2 microns below a top surface of substrate 101).

Although two transistors 103A and 103B are shown in FIGS. 1-2, an integrated circuit structure can be fabricated with any number of transistors on semiconductor structure 100. Transistors 103A and 103B share a common drain region 108. A gate 102A is associated with transistor 103A, and a gate 102B is associated with transistor 103B in some embodiments. Gates 102A and 102B can be a polysilicon material (e.g., heavily doped (P+)) disposed above a gate dielectric. The polysilicon material can be replaced with a metal material. The gate dielectric is a high K gate dielectric material (e.g., hafnium oxide, tantalum oxide, etc.) or an oxide material (thermally grown silicon dioxide, silicon oxynitride, etc. ) in some embodiments.

Drain region 108 is a highly doped N type region (e.g., concentration of 10¹⁹⁻²¹ dopants per cubic centimeter) in some embodiments. Drain region 108 has a depth of 30-80 nm and a width of 200-400 nm in some embodiments. Drain region 108 is provided in a well region 118 (e.g., an N well region moderately doped with N type dopants). Drain region 108 has a width of approximately 200-450 nm in some embodiments.

A source region 104A is associated with transistor 103A, and a source region 104B is associated with transistor 103B. Source regions 104A and 104B are highly doped N type regions (e.g., concentration of 10¹⁹⁻²¹ dopants per cubic centimeter) in some embodiments. Source regions 104A and 104B have a depth of 30-80 nm and a width of 200-400 nm in some embodiments. Source regions 104A and 104B can have a width smaller than the width (left-to-right in FIG. 1) of drain region 108 in some embodiments. Source regions 104A and 104B and drain region 108 each have a length (e.g., up and down direction in FIG. 1) that is greater than the width in some embodiments. In some embodiments, the length is the same size as the width. Drain region 108 and source regions 104A and 104B can have lightly doped portions that extend into the channel in some embodiments.

A region refers to a specific area or volume within the semiconductor substrate or layer above the substrate in some embodiments. The specific area or volume is intentionally modified or doped to have certain electrical properties in some embodiments. The region can have borders with sharp transitions or more gradual transitions. A region can be doped with specific impurities to alter their electrical conductivity. Regions can be provided using techniques such as ion implantation, diffusion, or epitaxy in some embodiments. Doping introduces additional charge carriers into the material, either by adding electrons (N type doping) or creating holes where electrons can move (P type doping). Dopants refer to a material that is used to perform doping or form doped regions in some embodiments. An N region is doped with elements that provide extra electrons (e.g., Phosphorus, Antimony, Arsenic, etc.), resulting in an excess of negative charge carriers (electrons), and a P region is doped with elements that create a deficit of electrons (e.g., Boron, Indium, etc.), resulting in an excess of positive charge carriers (holes). An undoped region or intrinsic region refers to an undoped or very lightly doped region or volume in some embodiments. A junction refers to an area or volume where regions of different doping types or concentrations can be brought into close proximity to form junctions or borders. A well region refers to a region in a semiconductor substrate that has been intentionally modified to create distinct electrical properties in some embodiments. The well region can serve to isolate or enhance certain device functionalities in some embodiments.

Well region 118 is provided in a well region 126 that is deeper than well region 118. Well region 126 is less deep than region 105 and is moderately doped (doped with N type dopants). The concentration of dopants in region 126 is less than the concentration of dopants in region 118 (e.g., more mildly doped than region 118) in some embodiments. Regions 118 and 126 have a concentration of 10¹⁵⁻¹⁷ dopants per cubic centimeter in some embodiments.

Gate 102A is partially provided over drain region 108, region 124, and well region 126 in some embodiments. Gate 102B is partially provided over drain region 108, region 124, and well region 126 in some embodiments. Region 124 is an undoped region having a depth greater than regions 122A and 122B and a depth less than region 105 in some embodiments.

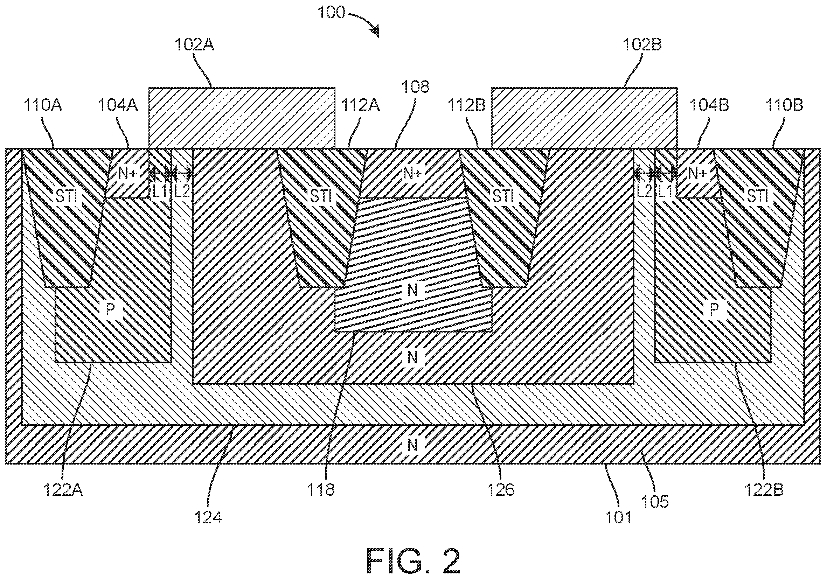

With reference to FIG. 2, source region 104A is provided in a well region 122A, and source region 104B is provided in a well region 122B. Well regions 122A and 122B are moderately doped with P type dopants (e.g., concentration of 10¹⁵⁻¹⁸ dopants per cubic centimeter). In some embodiments, regions 122A and 122B are doped to a concentration of 10¹⁵⁻¹⁷ dopants per cubic centimeter. Regions 122A and 122B are less deep than well region 126 and have a depth of approximately 50-200 nm in some embodiments. Well region 122A and source region 104A neighbors a shallow trench isolation (STI) structure 110A, and well region 122B and source region 104B neighbors a shallow trench isolation (STI) structure 110B. STI structures 112A and 112B are disposed in well region 126. Structure 110A is not as deep as region 122A, and structure 110B is not as deep as region 122B in some embodiments. Structures 110A, 110B, 112A and 112B can be foundry created structures having a 200 nm to 1.5 micron width and a 200 to 400 nm depth in some embodiments.

Gate 102A is partially provided over drain region 108, region 122A, region 124, region 126, and STI structure 112A in some embodiments. Gate 102A is partially provided over drain region 108, region 122B, region 124, region 126, and STI structure 112B in some embodiments. A length L1 (left to right on FIG. 2) exists between source region 104A and region 124 in region 122A and between drain region 108 and region 124 in region 122B in some embodiments. A length L2 exists between region 122A and region 126 in region 124 and between region 122B and region 126 in region 124 in some embodiments. L1 has a length of 0 to 150 nm (e.g., 10nm to 10 nm or 20-80 nm) in some embodiments. L2 has a length of 0 to 200 nm (e.g., 10 nm to 150 nm or 20-120 nm). In some embodiments, lengths L1 and L2 can be chosen for device performance. For example, longer gate widths and larger drain/source regions are achieved by adjusting lengths L1 and L2 in some embodiments. A conduction path or channel (N-channel) under gates 102A and 102B is provided from source region 104A to drain region 108 and source region 104B to drain region 108, respectively, via region 122A, region 126, and region 118 beneath structure 212A and via region 122B, region 126, and region 118 beneath structure 212B. The conduction path is an N-type channel provided in response to a gate to source voltage and drain to source voltage in some embodiments. Structures 110A, 110B, 112A, and 112B can have a trapezoidal cross sectional shape, and region 228 and regions 122A and 122B are wider at their bottom than at their top in some embodiments.

The position, characteristics, and sizes of the drain region 108 and source regions 104A and 104B can vary in some embodiments. The terms drain and source or drain and source regions refers to a source or a drain in some embodiments. The drain region 108 and source regions 104A and 104B are heavily doped N regions formed in an epitaxial or ion implantation process in some embodiments.

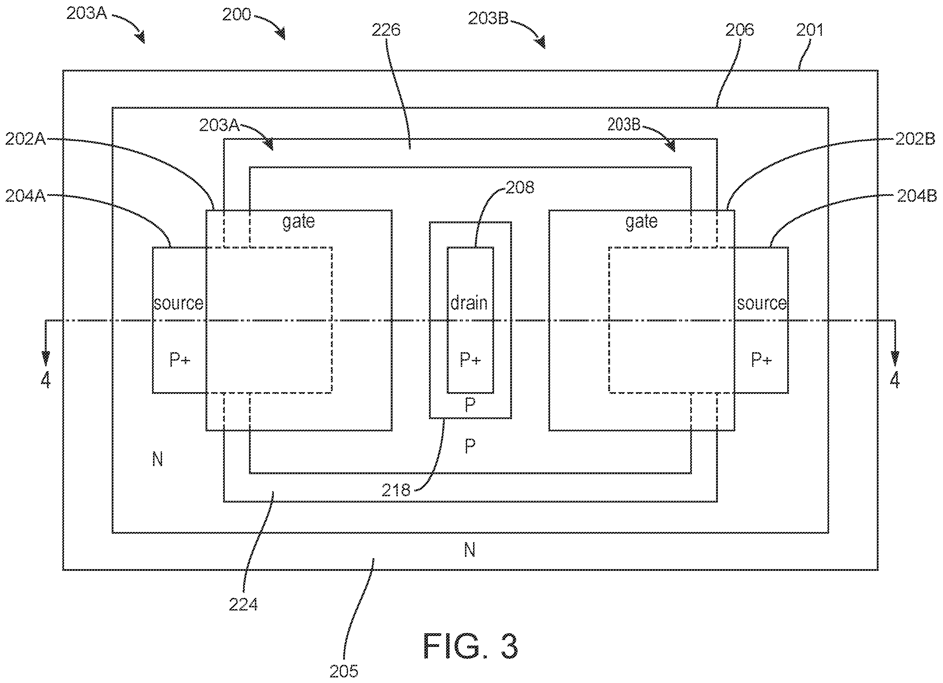

With reference to FIGS. 3-4, an integrated circuit or semiconductor structure 200 is disposed on an insulative, semi-insulative, or semiconductor substrate 201. Substrate 201 can be a P type, N type, or non-doped silicon substrate in some embodiments. A pair of transistors 203A and 203B are provided on or within substrate 201. In some embodiments, the substrate 201 can be formed using any suitable material, such as silicon, silicon germanium, germanium, etc. The substrate 201 can include other structures (not shown) similar to substrate 101 (FIG. 1). Substrate 201 is a bulk silicon substrate in some embodiments.

Substrate 201 includes a well region 205 provided around a perimeter of transistors 203A and 203B. Well region 205 is the deepest well region in substrate 201 and is moderately doped with N type dopants (e.g., concentration of 10¹⁵⁻¹⁷ dopants per cubic centimeter) in some embodiments. In some embodiments, well region 205 is a buried well region having a considerable depth (e.g., 500 nanometers (nm) to 2 microns below a top surface of substrate 201) in substrate 201.

Although two transistors 203A and 203B are shown in FIGS. 3-4, an integrated circuit structure can be fabricated with any number of transistors on semiconductor structure 200. Transistors 203A and 203B share a common drain region 208. A gate 202A is associated with transistor 203A, and a gate 202B is associated with transistor 203B in some embodiments. Gates 202A and 202B can be a polysilicon material (e.g., heavily doped (P+)) disposed above a gate dielectric. The polysilicon material can be replaced with a metal material. The gate dielectric is a high K gate dielectric material (e.g., hafnium oxide, tantalum oxide, etc.) or an oxide material (thermally grown silicon dioxide, silicon oxynitride, etc.) in some embodiments.

Drain region 208 is a highly doped P type region (e.g., concentration of 10¹⁹⁻²¹ dopants per cubic centimeter) in some embodiments. Drain region 208 has a depth of 30-80 nm and a width of 200-400 nm in some embodiments. Drain region 208 is provided in a well region 218 (e.g., a P well region moderately doped with P type dopants). Drain region 208 has a width of approximately 200-450 nm in some embodiments.

A source region 204A is associated with transistor 203A, and a source region 204B is associated with transistor 203B. Source regions 204A and 204B are highly doped P type regions (e.g., concentration of 10¹⁹⁻²¹ dopants per cubic centimeter) in some embodiments. Source regions 204A and 204B have a depth of 30-80 nm and a width of 200-400 nm in some embodiments. Source regions 204A and 204B can have a width smaller than the width (left-to-right in FIG. 3) of drain region 208 in some embodiments. Source regions 204A and 204B and drain region 208 each have a length (e.g., up and down direction in FIG. 3) that is greater than the width in some embodiments. In some embodiments, the length is the same size as the width. Drain region 208 and source regions 204A and 204B can have lightly doped portions that extend into the channel in some embodiments.

Well region 218 is provided in a well region 226 that is deeper than well region 218. Well region 226 is less deep than region 205 and is moderately doped (doped with P type dopants). The concentration of dopants in region 226 is less than the concentration of dopants in region 218 (e.g., more mildly doped than region 218) in some embodiments.

Gate 202A is partially provided over drain region 108, region 224, and well region 226 in some embodiments. Gate 202B is partially provided over drain region 208, region 224, and well region 226 in some embodiments. Region 224 is an undoped region having a depth greater than regions 222A and 222B and a depth less than region 205 in some embodiments.

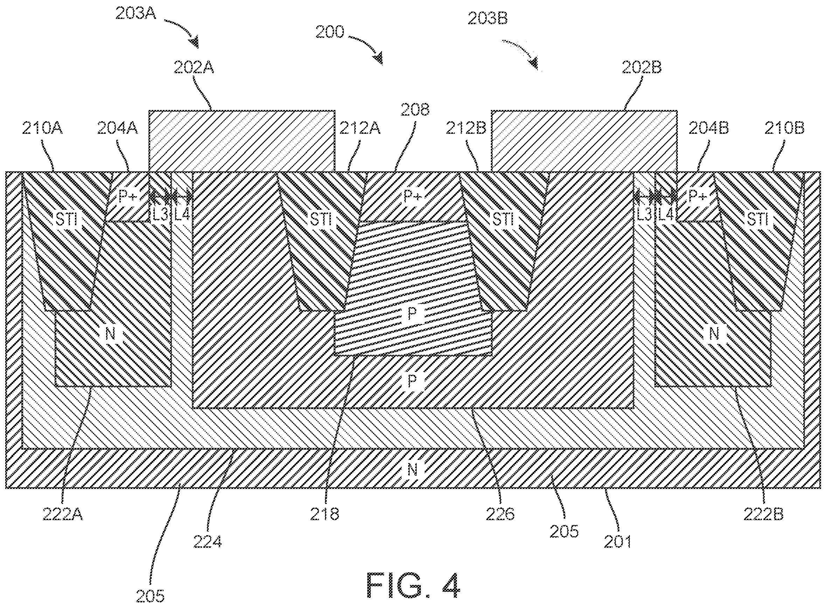

With reference to FIG. 4, source region 204A is provided in a well region 222A, and source region 204B is provided in a well region 222B. Well regions 222A and 222B are moderately doped with N type dopants (e.g., concentration of 10¹⁵⁻¹⁸ dopants per cubic centimeter). In some embodiments, regions 222A and 222B are doped to a concentration of 10¹⁵⁻¹⁷ dopants per cubic centimeter. Regions 222A and 222B are less deep than well region 226 and have a depth of approximately 50-200 nm in some embodiments. Well region 222A neighbors a shallow trench isolation (STI) structure 210A, and well region 222B neighbors a shallow trench isolation (STI) structure 210B. STI structures 212A and 212B are disposed in well region 226. Structure 210A is not as deep as region 222A, and structure 210B is not as deep as region 222B in some embodiments. Structures 210A, 210B, 212A and 212B can be foundry created structures having a 200 nm to 1.5 micron width and a 200 to 400 nm depth in some embodiments.

Gate 202A is partially provided over drain region 108, region 222A, region 224, region 226, and STI structure 212A in some embodiments. Gate 202A is partially provided over drain region 208, region 222B, region 224, region 226, and STI structure 212B in some embodiments. A length L3 exists between source region 204A and region 224 in region 222A and between source region 204B and region 224 in region 222B in some embodiments. A length L4 exists between region 222A and region 226 in region 224 and between region 222B and region 226 in region 224 in some embodiments. L3 has a length of 0 to 150 nm (e.g., 10 nm to 100 nm or 20-80 nm) in some embodiments. L4 has a length of 0 to 200 nm (e.g., 10 nm to 150 nm or 20-120 nm). In some embodiments, lengths L3 and L4 can be chosen for device performance For example, longer gate widths and larger drain/source regions are achieved by adjusting lengths L3 and L4 in some embodiments. A conduction path or channel (e.g., P-Channel) under gates 202A and 202B is provided from source region 204A to drain region 208 and source region 204B to drain region 208, respectively, via region 222A, region 226, and region 218 beneath structure 212A and via region 222B, region 226, and region 218 beneath structure 212B. The conduction path is a P-type channel provided in response to a gate to source voltage and drain to source voltage in some embodiments. Structures 210A, 210B, 212A, and 212B can have a trapezoidal cross sectional shape, and region 228 and regions 222A and 222B are wider at their bottom than at their top in some embodiments.

The position, characteristics, and sizes of the drain region 208 and source regions 204A and 204B can vary in some embodiments. The drain region 208 and source regions 204A and 204B are heavily doped N regions formed in an epitaxial or ion implantation process in some embodiments.

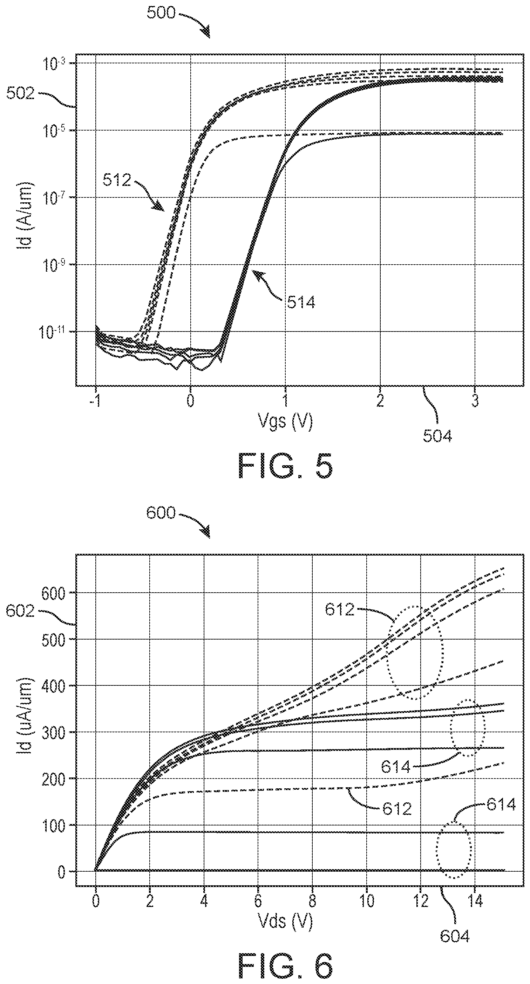

With reference to FIG. 5, a current versus voltage diagram 500 includes a Y axis 502 representing drain current in amps per micrometer and a Y axis 504 representing gate to source voltage in Volts. Curves 512 represent performance of a depletion mode N channel LD transistor (e.g., transistor 103A) across a set of drain to source voltages (e.g., .05 V, 3.79 V, 7.53 V, 11.27 V, and 15.01 V) according to some embodiments. Curves 514 represent performance of an enhancement mode N channel LD transistor across a set of drain to source voltages (e.g., .05 V, 3.79 V, 7.53 V, 11.27 V, and 15.01 V). With reference to FIG. 6, a current versus voltage diagram 600 includes a Y axis 602 representing drain current in microamps per micrometer and a Y axis 604 representing drain to source voltage in volts. Curves 612 represent performance of a depletion mode N channel LD transistor (e.g., transistor 103A) across a set of gate to source voltages (e.g., 0.9 V, 1.5 V, 2.1 V, 2.7 V, and 3.3 V) according to some embodiments. Curves 614 represent performance of an enhancement mode N channel LD transistor across a set of drain to source voltages (e.g., 0.9 V, 1.5 V, 2.1 V, 2.7 V, and 3.3 V). The depletion mode N channel LD transistor has a saturation threshold voltage of -0.132 V as compared to 0.819 V for an enhancement mode N channel LD transistor in some embodiments. The depletion mode N channel LD transistor has an on current of 648 microamperes per micrometer as compared to 358 microamperes per micrometer for an enhancement mode N channel LD transistor in some embodiments. The depletion mode N channel LD transistor has an on resistance of 6291 ohms per micrometer as compared to 6601 ohms per micrometer for an enhancement mode N channel LD transistor in some embodiments.

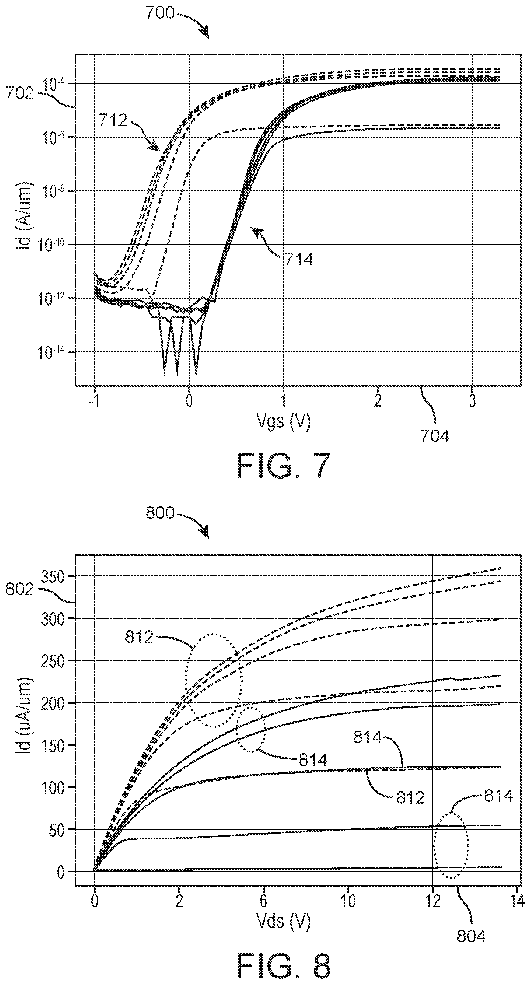

With reference to FIG. 7, a current versus voltage diagram 700 includes a Y axis 702 representing drain current in amps per micrometer and a Y axis 704 representing gate to source voltage in Volts. Curves 712 represent performance of a depletion mode P channel LD transistor (e.g., transistor 203A) across a set of drain to source voltages (e.g., .05 V, 6.04 V, 12.03 V, 18.02 V, and 24.01 V) according to some embodiments. Curves 714 represent performance of an enhancement mode P channel LD transistor across a set of drain to source voltages (e.g., .05 V, 6.04 V, 12.03 V, 18.02 V, and 24.01 V). With reference to FIG. 8, a current versus voltage diagram 800 includes a Y axis 802 representing drain current in microamps per micrometer and a Y axis 804 representing drain to source voltage in volts. Curves 812 represent performance of a depletion mode P channel LD transistor (e.g., transistor 203A) across a set of gate to source voltages (e.g., 0.9 V, 1.5 V, 2.1 V, 2.7 V, and 3.3 V) according to some embodiments. Curves 814 represent performance of an enhancement mode P channel LD transistor across a set of drain to source voltages (e.g., 0.9 V, 1.5 V, 2.1 V, 2.7 V, and 3.3 V). The depletion mode P channel LD transistor has a saturation threshold voltage of -0.357 V as compared to 0.613 V for an enhancement mode P channel LD transistor in some embodiments. The depletion mode P channel LD transistor has an on current of 356 microamperes per micrometer as compared to 231 microamperes per micrometer for an enhancement mode P channel LD transistor in some embodiments. The depletion mode P channel LD transistor has an on resistance of 15185 ohms per micrometer as compared to 22461 ohms per micrometer for an enhancement mode N channel LD transistor in some embodiments. The depletion mode P channel LD transistor can have a capacity of 24 V in some embodiments.

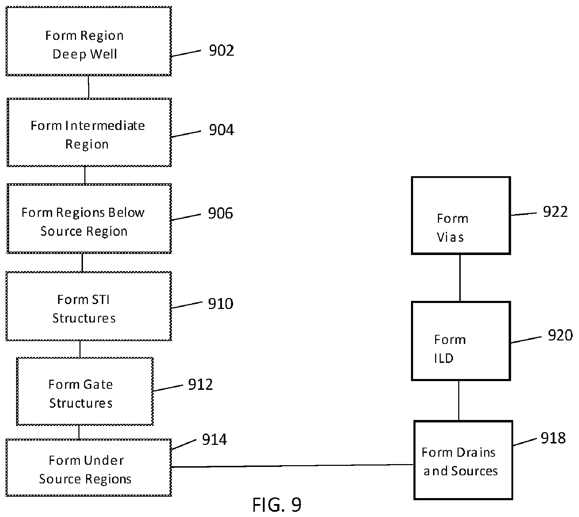

An exemplary flow 900 for fabricating the semiconductor structure 100 is described below with reference to FIGS. 1-2 and 9 according to some embodiments. Flow 900 is described for fabricating an N MOS transistor and can be modified to fabricate a PMOS transistor). With reference to FIG. 9, substrate 101 is masked and subjected to an ion implantation to form region 105 in an operation 902. Region 126 is formed above region 105 in an operation 904 in a similar process. Regions 122A and 122B are formed above region 105 in an operation 906 in a similar process. Operations 904 and 906 can include mask and ion implantation process. Trenches for structures 110A, 110B, 112A, and 112B are formed in an operation 910. A tetraethyl orthosilicate mask etch and fill process can be used to form structures 110A, 110B, 112A, and 112B.

In an operation 912, a gate dielectric material and a polysilicon gate material is deposited in a conformal deposition operation. The gate dielectric material and the polysilicon gate material are selectively removed in a lithographic etching process to leave gates 102A-B. In some embodiments, the polysilicon gate material is selectively removed in a lithographic etching process to leave the gates 102A-B. A reactive ion etching, (e.g., RIE), dry etching or other process selective to the polysilicon material can be be used to form the gates 102A-B according to some embodiments. In some embodiments, a dummy gate process is used where polysilicon material is replaced with a metal material such as a copper, aluminum or alloys thereof in some embodiments.

At an operation 914, regions 122A and 122B are formed. Regions 122A and 122B can be formed in an ion implantation process. The ion implantation process can include angled ion implantation. In an operation 918, the drain region 108 and source regions 104A and 104B are formed. An ion implantation epitaxial process can be used. An annealing operation can also be performed. The gates 102A-B or dummy gates and structures 110A, 110B, 112A and 122B can serve as a boundary against overgrowth. The dopants for the drain/source regions can be any suitable type of dopant, such as positive-type (P-type) or negative-type (N-type) dopants. The drain region 108 and source regions 104A and 104B are formed by selective ion implantation according to some embodiments.

At an operation 920, an interlevel dielectric is provided. The interlevel dielectric (ILD) is an oxide layer (SiO₂) deposited by chemical vapor deposition in some embodiments.

In an operation 922, conductive vias and contacts can be formed for the transistors 103A and 103B. Metallization layers can also be provided for the integrated circuit or semiconductor structure 100. The flow 900 advantageously does not require extra masks or extra process steps as compared to an enhancement mode transistor process in some embodiments.

The disclosure is described above with reference to drawings. These drawings illustrate certain details of specific embodiments that implement the systems and methods and programs of the present disclosure. However, describing the disclosure with drawings should not be construed as imposing on the disclosure any limitations that are present in the drawings. No claim element herein is to be construed as a "means plus function" element unless the element is expressly recited using the phrase "means for." Furthermore, no element, component or method step in the present disclosure is intended to be dedicated to the public, regardless of whether the element, component or method step is explicitly recited in the claims.

It should be noted that certain passages of this disclosure can reference terms such as "first" and "second" in connection with power level for purposes of identifying or differentiating one from another or from others. These terms are not intended to relate entities or operations (e.g., a first power level and a second power level) temporally or according to a sequence, although in some cases, these entities can include such a relationship. Nor do these terms limit the number of possible entities or operations.

It should be noted that although the flows provided herein show a specific order of method steps, it is understood that the order of these steps can differ from what is depicted. Also, two or more steps can be performed concurrently or with partial concurrence. Such variation will depend on the software and hardware systems chosen and on designer choice. It is understood that all such variations are within the scope of the disclosure.

While the foregoing written description of the methods and systems enables one of ordinary skill to make and use what is considered presently to be the best mode thereof, those of ordinary skill will understand and appreciate the existence of variations, combinations, and equivalents of the specific embodiment, method, and examples herein. The present methods and systems should therefore not be limited by the above described embodiments, methods, and examples, but by all embodiments and methods within the scope and spirit of the disclosure.

## Claims

1. A transistor (103A) comprising:
a first well region (122A) doped with second type dopants;
a second well region (126) doped with first type dopants;
a third well region (118);
a first isolation structure (110A) neighboring the first well region (122A);
a second isolation structure (112A) neighboring the second well region (126) and the third well region (118);
a drain region (108) doped with the first type dopants disposed in the third well region (118);
a source region (104A) doped with the first type dopants disposed in the first well region (122A); and
a gate (102A) disposed at least partially over the second isolation structure (112A), wherein the transistor (103A) is configured as a depletion mode transistor.

2. The transistor (103A) of claim 1, wherein a first distance (L1) in the first well region (122A) between the source region (104A) and an undoped region (124) is between 0 and 150 nanometers.

3. The transistor (103A) of claim 2, wherein a second distance (L2) in the undoped region (124) between the first well region (122A) and the second well region (126) is between 0 and 200 nanometers.

4. The transistor (103A) of any of claims 1 to 3, wherein a first distance (L1) in an undoped region (124) between the first well region (122A) and the second well region (126) is between 0 and 200 nanometers.

5. The transistor (103A) of any of claims 1 to 4, wherein the drain region (108) is a shared drain region (108).

6. The transistor (103A) of any of claims 1 to 5, wherein the first and second isolation structures (110A, 112A) have a depth, the depth being less than depths of the second well region (126) and the first well region (122A).

7. The transistor (103A) of any of claims 1 to 6, further comprising:
an undoped region (124) between a bottom of the first well region (122A) and the third well region (118) and between the second well region and the third well region (118).

8. The transistor (103A) of any of claims 1 to 7, wherein the third well region (118) is doped with N type dopants.

9. An integrated circuit (100), comprising:
a first well region (122A) doped with second type dopants;
a second well region (126) doped with first type dopants;
a third well region (118);
a drain region (108) doped with the first type dopants disposed in the third well region (118);
a source region (104A) doped with the first type dopants disposed in the first well region (122A); and
a gate (102A) disposed between the source region (104A) and the drain region (108), wherein a first distance (L1) in the first well region (122A) between the source region (104A) and an undoped region (124) is between 0 and 150 nanometers.

10. The integrated circuit (100) of claim 9, wherein a second distance (L2) in the undoped region (124) between the first well region (122A) and the second well region (126) is between 0 and 200 nanometers.

11. The integrated circuit (100) of claim 9 or 10, further comprising:
a first isolation structure (110A) neighboring the first well region (122A);
a second isolation structure (112A) neighboring the second well region (126) and the third well region (118).

12. The integrated circuit (100) of any of claims 9 to 11, wherein the drain region (108) is a shared drain region (108).

13. The integrated circuit (100) of any of claims 9 to 12, comprising at least one of the following features:
(i) wherein the first and second isolation structures (110A, 112A) have a depth, the depth being less than depths of the second well region (126) and the first well region (122A);
(ii) wherein the undoped region (124) between a bottom of the first well region (122A) and the third well region (118) and between the second well region and the third well region (118);
(iii) wherein the third well region (118) is doped with N type dopants.

14. A method comprising:
Providing a deep well (105) doped with N type dopants;
forming a first well region (122A) doped with first type dopants above the deep well (105), the first type dopants being one of the N type dopants or P type dopants;
forming a second well region (126) doped with second type dopants above the deep well (105), the second type dopants being the other of the N type dopants or the P type dopants;
forming a first shallow trench isolation structure;
forming a gate (102A);
forming a source region (104A) between the gate (102A) and the first shallow trench isolation structure above the first well region (122A); and
forming a drain region (108) in the second well region (126), wherein a first distance (L1) in the first well region (122A) between the source region (104A) and an undoped region (124) is between 0 and 150 nanometers.

15. The method of claim 14, comprising at least one of the following features:
(i) wherein a second distance (L2) in the undoped region (124) between the first well region (122A) and the second well region (126) is between 0 and 200 nanometers;
(ii) further comprising:
forming a second shallow trench isolation structure neighboring the second well region (126) and the drain region (108);
(iii) wherein the undoped region (124) is between the first well region (122A) and the deep well (105);
(iv) wherein the second well region (126) is provided in a third well region (118) doped with the other dopants of the N type dopants or the P type dopants.
